**Europäisches Patentamt**

**European Patent Office**

**Office européen des brevets**

(19)

(11) Publication number: **0 111 655**
**A1**

(12) **EUROPEAN PATENT APPLICATION**

(21) Application number: **83109943.7**

(22) Date of filing: **05.10.83**

(51) Int. Cl.³: **G 03 F 7/20**
**G 03 F 7/10**

(30) Priority: **18.11.82 US 442495**

(43) Date of publication of application:
**27.06.84 Bulletin 84/26**

(84) Designated Contracting States:
**DE FR GB**

(71) Applicant: **International Business Machines Corporation**
**Old Orchard Road**
**Armonk, N.Y. 10504(US)**

(72) Inventor: **Ito, Hiroshi**
**7221 Via Colina**
**San Jose California 95139(US)**

(72) Inventor: **Willson, Carlton Grant**
**896 Harding Avenue**
**San Jose California 95126(US)**

(74) Representative: **Hobbs, Francis John**
**IBM United Kingdom Patent Operations Hursley Park**
**Winchester, Hants, SO21 2JN(GB)**

(54) Processes for producing positive self-developed photo resist patterns.

(57) Positive self-developed photo-resist patterns are obtained by selectively exposing a polyacetal layer to excimer laser radiation.

EP 0 111 655 A1

## PROCESSES FOR PRODUCING POSITIVE SELF-DEVELOPED
## PHOTO RESIST PATTERNS

This invention relates to processes for producing self-developed positive photo-resist patterns.

Processes for producing self-developed resist patterns, i.e. processes that do not require post-exposure processing such as the application of a solvent or heat, have been sought for some time. The interest in such processes throughout the semiconductor industry stems from the potential they provide for higher throughput and higher yields. The higher yields result from both the reduction in process steps and the fact that such processes provide the potential for carrying out exposure, development, and pattern transfer (etch, implant, or deposition) under high vacuum, thereby reducing defects due to atmospheric contaminants, airborne particulate matter and development process.

US-A-3,915,704 discloses a process for producing a self-developed pattern comprising exposing selected portions of a layer containing polyacetal to light. The layer also contains (1) a polymer capable of undergoing photo-induced dehyrohalogenation and (2) an electron acceptor.

Published European Patent application A1-66053, describes the use of excimer laser radiation in lithography. Self development is not possible with any of the materials which are mentioned in that application.

The invention provides a self-developing process using polyacetals without the need for any sensitizer.

According to one aspect of the invention, a process for producing a positive photo-resist pattern comprising exposing selected portions of a polyacetal layer to radiation, is characterised, according to the invention, by the radiation being excimer laser radiation.

According to another aspect of the invention, a process for producing a positive self-developed photo-resist pattern comprising exposing selected portions of a photo-resist layer containing polyacetal to radiation, is characterised, according to the invention, by the photo-resist layer consisting solely of polyacetal and the radiation being excimer laser radiation.

Polyacetals useful in the present invention include those formed from aromatic dialdehydes such as phthalaldehyde and o-formylphenylacetaldehyde, alkyl aldehydes, halogenated alkyl aldehydes and copolymers thereof. The most preferred polyacetal is from polymerized phthalaldehyde, capped with an acetyl group.

By means of the present invention, the resist films are completely developed down to the substrate without the need for any additional processing such as heating, plasma etching or solvent development. To obtain this extremely advantageous result, it is necessary that the resist material be a polyacetal and the radiation be excimer laser radiation. We postulate that thermodynamically unstable polyacetal stabilized by end capping, unzips to the monomer upon exposure to high intensity excimer laser radiation to provide a self-developing positive resist. This action is unique to the excimer laser exposure system. Excimer laser exposure of a wide range of other materials does not produce self development. Also, exposure of capped polyphthalaldehyde to low flux density mercury lamp radiation does not produce self development.

The following example is given solely for the purpose of illustration and is not to be considered a limitation on the invention.

Example

Polyphthalaldyhydes were synthesized by anionic mechanism with any of several initiators under high vacuum and end capped with an acetyl group. Molecular weights (Mw) ranged from $1.7 \times 10^4$ to $9.7 \times 10^4$ with low dispersity ($1.1 \sim 1.8$). The polymers were thermally stable to 175°C. Above that temperature, thermogravametric analysis (TGA) showed very sharp weight loss due to depolymerization and vaporization.

In a typical process of the present invention, a polyacetal such as the polymer from phthalaldehyde capped with acetyl, was dissolved in cyclohexanone to make a 20 w/v% solution, spin coated on silicon wafers at 2000 rpm for 30 seconds to give a 1 μ thick films, and prebaked at 100°C for 30 minutes. The films were imagewise exposed through a brick-pattern mask to 40, 60 and 80 pulses of KrF excimer laser radiation (249 nm) at a flux of 66 mJ/$cm^2$/pulse. The pulse interval was 100Hz. Each exposure was completed within a second. The resist films were completely self-developed to the substrate by the exposure without further processing such as heating, plasma etching and solvent development. Optical and scanning-electron micrographs of the self-developed resist patterns show that image qualities and resolution were excellent, and the films in the unexposed areas were unchanged. The invention has the additional advantage that the unexposed resist is stable to a variety of image transfer processes.

CLAIMS

1.    A process for producing a positive photo-resist pattern comprising exposing selected portions of a polyacetal layer to radiation, characterised by the radiation being excimer laser radiation.

2.    A process for producing a positive self-developed photo-resist pattern comprising exposing selected portions of a photo-resist layer containing polyacetal to radiation, characterised by the photo-resist layer consisting solely of polyacetal and the radiation being excimer laser radiation.

3.    A process as claimed in claim 1 or claim 2, in which the polyacetal is an acetyl capped polyphthalaldehyde.

4.    A process as claimed in any preceding claim, in which the excimer laser radiation is high power pulsed radiation.

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| X,Y | US-A-3 549 733 (J.R. CADDELL) * Whole document * | 1-4 | G 03 F 7/20 G 03 F 7/10 |
| X,Y | DE-A-2 937 275 (CROSFIELD) * Whole document * | 1-4 | |
| Y | APPLIED PHYSICS LETTERS, vol. 41, no. 6, 15th September 1982, pages 576-578 R. SRINIVASAN et al.: "Self-developing photoetching of poly(ethylene terephthalate) films by far-ultraviolet excimer laser radiation" * Whole article * | 1-4 | |
| Y | XEROX DISCLOSURE JOURNAL, vol. 1, no. 2, February 1976, page 17 W.W. LIMBURG et al.: "Imaging method based on photo-induced depolymerization of poly(acetaldehyde)" * Whole article * | 1-4 | TECHNICAL FIELDS SEARCHED (Int. Cl. 3)  G 03 F 7/20 G 03 F 7/10 |
| Y | US-A-4 086 092 (E. GOLDA) * Column 4, lines 30-56; claim 7 * | 1-4 | |

-/-

The present search report has been drawn up for all claims

| Place of search | Date of completion of the search | Examiner |
|---|---|---|
| THE HAGUE | 23-02-1984 | RASSCHAERT A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82

## DOCUMENTS CONSIDERED TO BE RELEVANT

Page 2

| Category | Citation of document with indication, where appropriate, of relevant passages | Relevant to claim | CLASSIFICATION OF THE APPLICATION (Int. Cl ³) |
|---|---|---|---|
| Y | JAPANESE JOURNAL OF APPLIED PHYSICS, vol. 20, no. 10, October 1981, pages L709-L712, Tokyo, JP. N. UENO et al.: "Direct etching of resists by UV light" * Whole article * | 1-4 | |
| Y | IEEE ELECTRON DEVICE LETTERS, vol. EDL-3, no. 3, March 1982, pages 53-55, K. JAIN et al.: "Ultrafast deep UV lithography with excimer lasers" * Whole article * | 1-4 | |
| Y | JOURNAL OF APPLIED PHYSICS, vol. 53, no. 9, September 1982, pages 6489-6490 Y. KAWAMURA et al.: "Deep UV submicron lithography by using a pulsed high-power excimer laser" * Whole article * | 1-4 | |
| Y | IBM J. RES. DEVELOP., vol. 26, no. 2, March 1982, pages 151-159 K. JAIN et al.: "Ultrafast high-resolution contact lithography with excimer lasers" * Whole article * | 1-4 | **TECHNICAL FIELDS SEARCHED (Int. Cl. ³)** |
| E | EP-A-0 096 895 (HITACHI) * Claims * | 1-4 | |

-/-

The present search report has been drawn up for all claims

| Place of search THE HAGUE | Date of completion of the search 23-02-1984 | Examiner RASSCHAERT A. |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| P,X | CHEMICAL ABSTRACTS, vol. 99, 4th July 1983; page 542, no. 166881g, Columbus, Ohio, USA C.G. WILLSON et al.: "Chemical amplification in the design of polymers for resist applications" & PROC. IUPAC, I.U.P.A.C., MACROMOL. SYMP., 28th 1982, 448 * Abstract * | 1-4 | |

-----

TECHNICAL FIELDS SEARCHED (Int. Cl. ³)

The present search report has been drawn up for all claims

| Place of search | Date of completion of the search | Examiner |
|---|---|---|
| THE HAGUE | 23-02-1984 | RASSCHAERT A. |